Europäisches Patentamt

European Patent Office

Office européen des brevets

(19)

(11) Veröffentlichungsnummer: **0 218 829 B1**

# (12) EUROPÄISCHE PATENTSCHRIFT

(45) Veröffentlichungstag der Patentschrift: 06.11.91

(21) Anmeldenummer: 86110819.9

(22) Anmeldetag: 05.08.86

(51) Int. Cl.5: **H01J 37/28**, H01J 37/252, G01R 31/28

(54) Anordnung zur Detektion von Sekundär- und/oder Rückstreuelektronen in einem Elektronenstrahlgerät.

(30) Priorität: 13.09.85 DE 3532781

(43) Veröffentlichungstag der Anmeldung:
22.04.87 Patentblatt 87/17

(45) Bekanntmachung des Hinweises auf die
Patenterteilung:
06.11.91 Patentblatt 91/45

(84) Benannte Vertragsstaaten:
DE FR GB NL

(56) Entgegenhaltungen:
EP-A- 0 156 913

(73) Patentinhaber: SIEMENS AKTIENGESELL-
SCHAFT
Wittelsbacherplatz 2
W-8000 München 2(DE)

(72) Erfinder: Lischke, Burkhard, Prof. Dr.
In der Heuluss 13
W-8000 München 82(DE)
Erfinder: Rose, Harald, Prof. Dr.
Prinz-Christian-Weg 5 1/2
W-6100 Darmstadt(DE)
Erfinder: Zach, Joachim, Dipl.-Phys.
Neckarstrasse 2
W-6085 Nauheim(DE)

**Beschreibung**

Die Erfindung bezieht sich auf eine Anordnung zur Detektion von Sekundär- und/oder Rückstreuelektronen in einem Elektronenstrahlgerät nach dem Oberbegriff des Patentanspruchs 1.

Herkömmliche Anordnungen dieser Art haben den Nachteil, daß der Primärstrahl durch das für die Sekundärelektronen vorgesehene elektrische Absaugfeld in seiner Richtung beeinflußt wird. Das ist insbesondere dann der Fall, wenn der Primärstrahl mit einer relativ niedrigen Beschleunigungsspannung von zum Beispiel 1 kV erzeugt wird.

Der Erfindung liegt die Aufgabe zugrunde, eine Anordnung der eingangs genannten Art anzugeben, bei der der genannte Nachteil nicht auftritt. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß die Richtung des Primärstrahls auch bei niedrigen Beschleunigungsspannungen durch das zum Absaugen der Sekundärelektronen vorgesehene elektrische Feld nicht nennenswert beeinflußt wird.

Die Patentansprüche 2 bis 11 sind auf bevorzugte Ausgestaltungen und Weiterbildungen der Erfindung gerichtet.

Die Erfindung wird nachfolgend anhand der Zeichnung näher erläutert. Dabei zeigt:

Figur 1    ein erstes Ausführungsbeispiel der Erfindung,

Figur 2    Bahnen von Sekundärelektronen, die bei der Anordnung nach Figur 1 auftreten,

Figur 3    ein zweites Ausführungsbeispiel, das für extrem niedrige Beschleunigungsspannungen geeignet ist,

Figur 4    ein drittes Ausführungsbeispiel, bei dem die Elektronen im Innenraum der Objektivlinse detektiert werden, und

Figur 5    ein viertes Ausführungsbeispiel, bei dem die Elektronen auf der von der Probe abgewandten Seite der Objektivlinse detektiert werden.

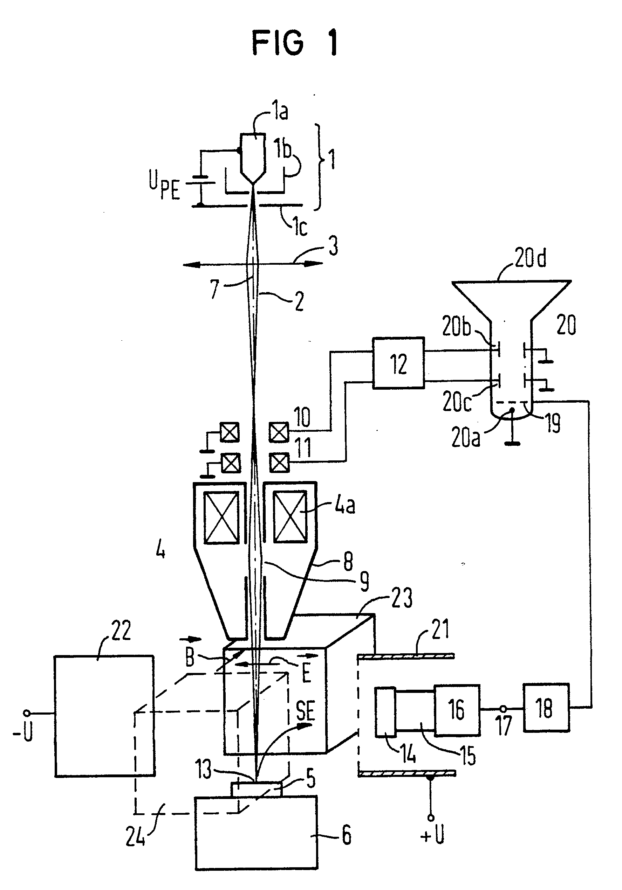

In Figur 1 ist ein Rasterelektronenmikroskop schematisch dargestellt. Es umfaßt eine Elektronenstrahlquelle 1, bestehend aus einer Kathode 1a, einem Wehneltzylinder 1b und einer Anode 1c, wobei zwischen 1c und 1a eine Beschleunigungsspannung $U_{PE}$ angelegt ist. Der durch eine Öffnung von 1c austretende Elektronenstrahl 2, der im folgenden als Primärstrahl bezeichnet werden soll, wird mittels einer Kondensorlinse 3 und weiterer elektronenoptischer Linsen, von denen lediglich die im Strahlengang als letzte vorgesehene Objektivlinse 4 dargestellt ist, auf einen Punkt 13 einer Probe 5, zum Beispiel einer integrierten Schaltung, fokussiert, die auf einem Probentisch 6 gehalten wird. Die Achse des elektronenoptischen Systems ist dabei mit 7 bezeichnet. Die Objektivlinse 4 ist mit einem metallischen Mantel 8 versehen, der einen Luftspalt 9 enthält, durch den das von der Spule 4a erzeugte Linsenfeld auf den Primärstrahl 2 einwirkt. Mittels zweier Ablenkspulensysteme 10 und 11, die von einem Rastergenerator 12 angesteuert werden, kann der Primärstrahl 2 in nebeneinander liegenden Zeilen über einen Bereich der Probenoberfläche abgelenkt werden. Beim Auftreffen des Primärstrahls treten am Punkt 13 Sekundärelektronen SE und Rückstreuelektronen aus der Probe 5 aus und gelangen über ein elektrisches Absaugfeld zu einem Szintillator 14, der über einen Lichtleiter 15 mit einem Fotomultiplier 16 verbunden ist. An dessen Ausgang 17 ist ein elektrisches Signal abgreifbar, das für den jeweils vom Primärstrahl 2 aufgesuchten Punkt 13 der Probenoberfläche charakteristisch ist.

Über eine Signalverarbeitung 18 wird aus dem elektrischen Signal ein Steuersignal abgeleitet, das der Intensitätssteuerelektrode 19 einer Bildröhre 20 zugeführt wird. Diese weist eine Kathode 20a, Ablenksysteme 20b und 20 c zur Beeinflussung eines von 20a ausgehenden Elektronenstrahls und einen Bildschirm 20d auf. Wird der Elektronenstrahl der Bildröhre 20 in einer der Ablenkung des Primärstrahls 2 entsprechenden Weise über den Bildschirm 20d abgelenkt, so erhält jeder Bildpunkt auf dem Bildschirm 20d, der einem durch den Primärstrahl 2 abgetasteten Punkt 13 der Probe 5 jeweils entspricht, eine dem jeweiligen elektrischen Signal entsprechende Helligkeit. Dabei entsteht ein Bild der Probenoberfläche auf dem Bildschirm 20d. Die aus den Teilen 14 bis 17 bestehende Anordnung wird auch als Rückstreudetektor bezeichnet.

Zwischen der Objektivlinse 4 und der Probe 5 sind in einer zur Achse 7 senkrechten Ebene zwei Elektroden 21 und 22 angeordnet, von denen die erste mit einer Spannung + U und die zweite mit einer Spannung - U beschaltet ist. Damit besteht zwischen beiden ein elektrisches Absaugfeld, das auf ein Elektron, das sich in ihm befindet, eine zur Elektrode 21 hin gerichtete Kraft ausübt. In der Ebene der Elektroden 21 und 22 befinden sich außerdem zwei Magnetpolstücke, die bei dem in Figur 1 dargestellten Ausführungsbeispiel quaderförmig ausgebildet sind. Das vor der Zeichenebene von Figur 1 liegende Magnetpolstück 24, das einen positiven Pol darstellt, ist gestrichelt angedeutet, während das hinter der Zeichenebene liegende Magnetpolstück 23, das einen negativen Pol darstellt, mit ausgezogenen Linien gezeichnet ist. Zwischen 23 und 24 liegt ein Magnetfeld, das durch einen von 24 ausgehenden und auf 23 gerichteten Feldstärkevektor $\vec{B}$ angedeutet ist. $\vec{B}$ steht dabei

senkrecht auf den das elektrische Feld zwischen 21 und 22 kennzeichnenden Feldstärkevektor $\vec{E}$, der von 21 ausgeht und auf 22 gerichtet ist.

Bezeichnet man den Betrag der elektrischen Feldstärke mit E und den der magnetischen Feldstärke mit B, so wird auf ein in der Nähe der Achse 7 befindliches Elektron des Primärstrahls 2 mit der Elementarladung q vom elektrischen Feld eine in Richtung von 22 nach 21 wirkende Kraft q.E ausgeübt. Gleichzeitig wird jedoch auf dieses Elektron, das sich mit der Geschwindigkeit v in Abwärtsrichtung auf die Probe 5 zu bewegt, von dem Magnetfeld zwischen den Teilen 23 und 24 eine sogenannte Lorentzkraft mit der Größe q.v.B ausgeübt, die in Richtung von 21 nach 22 einwirkt. Genügen die Größen E, B und v der Beziehung $v = \frac{E}{B}$, so werden die Elektronen des Primärstrahls 2 durch das Absaugfeld zwischen 21 und 22 nicht beeinflußt, das heißt nicht aus ihrer etwa parallel zur Achse 7 verlaufenden Flugbahn ausgelenkt. Jedes Sekundärelektron, das sich von der Probe in Richtung nach oben wegbewegt oder eine Austrittsgeschwindigkeitskomponente in dieser Richtung aufweist, wird dagegen durch das Magnetfeld mit einer Lorentzkraft beaufschlagt, die in Richtung von 22 nach 21 einwirkt, so daß der Absaugvorgang hierdurch noch unterstützt wird. Die abgesaugten Sekundärelektronen gelangen durch das Gitter 21a der Elektrode 21 zum Szintillator 14. Neben den Sekundärelektronen gelangen im allgemeinen auch Rückstreuelektronen, das heißt am Punkt 13 wieder austretende Primärelektronen, zum Szintillator 14.

Damit wird durch die Teile 21 bis 24 und durch die Bemessung des zwischen ihnen wirkenden, gekreuzten elektrisch-magnetischen Dipolfeldes ein sehr wirkungsvolles Absaugen der Elektronen SE erreicht, ohne daß hierdurch der Primärstrahl 2 in seiner Richtung nennenswert beeinflußt wird.

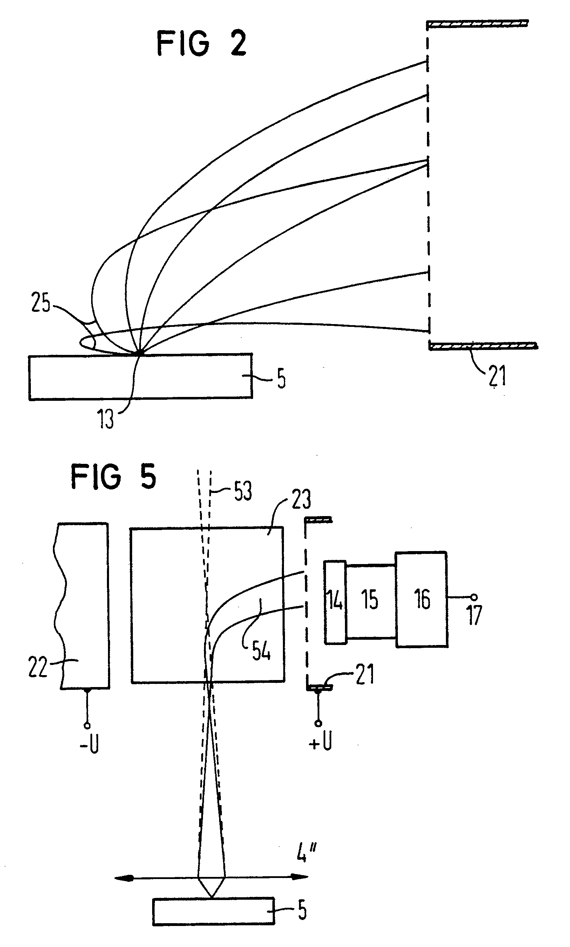

Figur 2 läßt die Flugbahnen verschiedener am Punkt 13 aus der Probe 5 austretender Sekundärelektronen erkennen, die in Richtung auf die Elektrode 21 hin verlaufen. Das gilt auch für Sekundärelektronen, deren Austrittsbahnen, zum Beispiel bei 25, zunächst in Richtung auf die Elektrode 22 hin verlaufen.

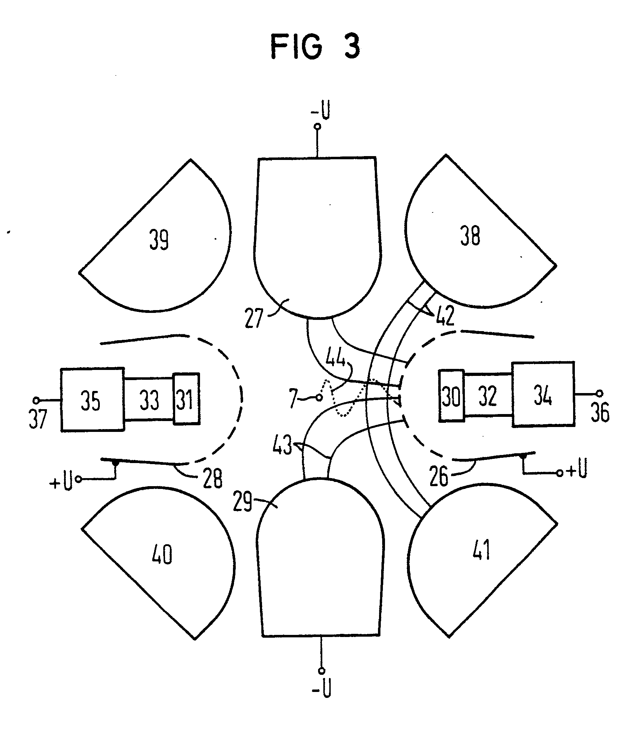

Figur 3 zeigt, daß bei einem anderen Ausführungsbeispiel der Erfindung die Elektroden 21, 22 und Magnetpolstücke 23, 24 von Figur 1 durch eine andere, in der gleichen Ebene angeordnete Konfiguration von Elektroden und Magnetpolstücken ersetzbar sind, wobei diese Konfiguration in Draufsicht dargestellt ist. Hier sind vier Elektroden 26 bis 29 jeweils entlang der Seitenlinien eines nicht gezeigten Quadrates angeordnet, dessen Mittelpunkt etwa in der elektronenoptischen Achse 7 liegt. Die Elektroden 26 und 28, die etwa symmetrisch zu dieser Achse angeordnet sind, sind mit einer Spannung + U beschaltet, die Elektroden 27 und 29 mit einer Spannung - U. Zwischen den Elektroden 26 und 29 und den Elektroden 26 und 27 besteht ein Absaugfeld, das die Elektronen jeweils zur Elektrode 26 hin transportiert, zwischen den Elektroden 28 und 27 und den Elektroden 28 und 29 ein Absaugfeld, das die Elektronen jeweils zur Elektrode 28 hin absaugt. Die Elektroden 26 und 28 sind in den Bereichen, die der optischen Achse 7 zugekehrt sind, gitterförmig ausgebildet, wobei die abgesaugten Elektronen durch diese Gitter zu Szintillatoren 30 und 31 gelangen, welche über Lichtleiter 32 und 33 mit Fotomultipliern 34 und 35 verbunden sind. Die Ausgänge 36 und 37 der letzteren werden den Eingängen einer Additions- oder Substraktionsstufe zugeführt, deren Ausgang dem Ausgang 17 von Figur 1 entspricht.

Weiterhin sind vier Magnetpolstücke 38 bis 41 vorgesehen, die jeweils zwischen den Elektroden 26 bis 29 liegen. Die zur Achse 7 etwa symmetrisch angeordneten Magnetpolstücke 38 und 40 stellen magnetische Nordpole dar, die Stücke 39 und 41 magnetische Südpole. Damit besteht zwischen 38 und 41 ein durch die Feldlinien 42 angedeutetes Magnetfeld, das auf dem für die Elektrode 26 wirksamen Absaugfeld (Feldlinien 43) senkrecht steht. Ebenso besteht zwischen 40 und 39 ein Magnetfeld, das auf dem für die Elektrode 28 wirksamen Absaugfeld senkrecht steht. Wie in Figur 3 gezeigt ist, können sich die Magnetpolstücke 38 bis 41 von der Achse 7 aus gesehen auch teilweise hinter den Elektroden befinden, bzw. weiter von 7 entfernt sein als die Elektroden, wenn die letzteren aus einem Material (zum Beispiel Messing) mit einer Permeabilität μ von etwa gleich 1 bestehen. Die Elektroden 26 bis 29 weisen zweckmäßig jeweils den gleichen Abstand von der Achse 7 auf, ebenso wie die Magnetpolstücke 38 bis 41, wobei sich der Abstand der letzteren von dem der ersteren unterscheiden kann, aber nicht unterscheiden muß. Die Feldstärken der elektrischen und magnetischen Felder des elektrisch-magnetischen Quadrupols nach Figur 3 werden so gewählt, daß sich deren Wirkungen auf den Primärstrahl 2 gegenseitig kompensieren. Die Elektronen werden sehr wirkungsvoll zu den Elektroden 26 und 28 hin abgesaugt, wobei sich die Wirkungen der elektrischen und magnetischen Felder verstärken. Mit 44 ist in Figur 3 die Bahn eines von 26 abgesaugten Sekundärelektrons bezeichnet, das eine Komponente der Austrittsgeschwindigkeit in Richtung auf die Elektrode 27 hin aufweist.

Bei einer Anordnung nach Figur 3 beeinflussen die chromatischen und geometrischen Bildfehler höherer Ordnung den Primärstrahl 2 selbst bei hoher örtlicher Auflösung auf der Probe 5 nur unwesentlich. Daher eignet sich eine solche Anordnung insbesondere zum Einsatz bei Elektronenstrahlgeräten mit Beschleunigungsspannungen $U_{PE}$,

die kleiner sind als 1 kV, und bei Auflösungsgrenzen, die kleiner sind als 0,1 µm.

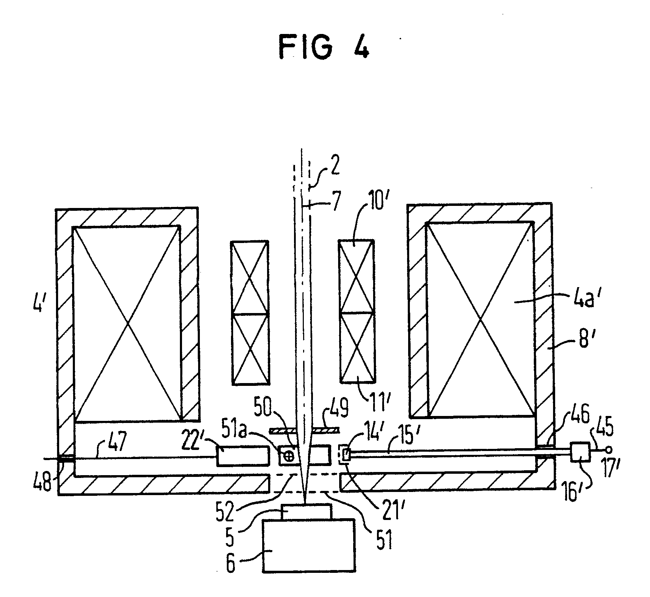

Figur 4 zeigt ein Ausführungsbeispiel, bei dem der Arbeitsabstand zwischen der Projektionslinse 4' und der Probe 5 so klein ist, daß das elektrisch-magnetische Detektorfeld nach Figur 1 nicht mehr zwischen diesen Teilen angeordnet werden kann. Die Wicklung 4a' der Projektionslinse ist von einem metallischen Mantel 8' umgeben, der wieder einen Luftspalt für die Beeinflussung des Primärstrahls 2 durch das Spulenfeld aufweist. In diesem Luftspalt sind Elektroden 21' und 22' vorgesehen, von denen 21' mit einer Spannung + U beschaltet ist, 22' mit einer Spannung - U. Ein aus einem Szintillator 14', einem Lichtleiter 15' und einem Fotomultiplier 16' bestehender Detektor ist hinter der gitterförmig gestalteten Elektrode 21' vorgesehen. Der Lichtleiter 15' ist durch eine Bohrung 46 des metallischen Mantels 8' aus dem Innenraum der Linse herausgeführt und zu dem außerhalb derselben liegenden Fotomultiplier 16' geführt. Eine Ausgangsleitung 45 des Fotomultipliers 16' führt dann zu einem Anschluß 17'. 22' ist über eine Leitung 47 mit der Spannung - U beschaltet, wobei 47 in einer Bohrung 48 des Mantels 8' verlegt ist. Mit 49 ist eine Aperturblende bezeichnet. Die Ablenkspulensysteme 10' und 11' befinden sich zweckmäßigerweise im Innenraum der Linse 4', und zwar im Bereich der Spulenwicklung 4a'. Die mit Bezugsstrichen versehenen Bezugszeichen sind Teilen zugeordnet, die den mit denselben Bezugszeichen versehenen Teilen aus Figur 1 entsprechen.

Senkrecht zu dem zwischen 21' und 22' bestehenden elektrischen Absaugfeld ist wieder ein magnetisches Feld vorgesehen, das durch ein hinter der Zeichenebene liegendes Magnetpolstück 50 (negativer Magnetpol) angedeutet ist.

Vor der Zeichenebene befindet sich ein weiteres (nicht dargestelltes) Magnetpolstück, das den positiven Magnetpol darstellt. Das zwischen diesen bestehende Magnetfeld ist durch ein Symbol 51a eines in die Bildebene gerichteten Feldstärkevektors angedeutet. Wegen der gegenseitigen Kompensation der Wirkungen des zwischen 21' und 22' bestehenden Absaugfeldes und des magnetischen Feldes 51a in bezug auf die Elektronen des Primärstrahls 2 wird dieser in seiner Richtung nicht beeinflußt, obwohl sich die Teile 21', 22' und 50 im Luftspalt von 8' befinden. Das Absaugen der Elektronen, das heißt insbesondere der Sekundärelektronen, wird durch die Wirkung des Magnetfeldes in der bereits beschriebenen Weise unterstützt. Soll der Detektor im Rahmen eines Elektronen-Spektrometers verwendet werden, so können Spektrometergitter 51, 52 vorgesehen sein, die in der Bohrung des unteren horizontal verlaufenden Teiles des metallischen Mantels 8' angeordnet sind. Dabei kann das Gitter 51 für den Einsatz in einem Bremsfeldspektrometer zum Beispiel zum Absaugen der Elektronen auf einer Spannung von + 600 Volt liegen, das Gitter 52 zum Filtern der Elektronen auf einer Spannung von - 4 Volt und die Elektrode 21' auf einer Spannung von 120 Volt. Ein Spektrometer dieser Art ist in Scanning Electron Microscopy/1979/I, SEM Inc, AMF O'Hare, III 60606, USA, auf den Seiten 285 bis 296, insbesondere Figur 5, beschrieben. Das in den Luftspalt von 8' wie vorstehend beschrieben eingefügte elektrisch-magnetische Dipolfeld kann auch durch einen elektrisch-magnetischen Quadrupol nach Figur 3 ersetzt werden, um chromatische und geometrische Bildfehler höherer Ordnung auszuschalten.

Figur 5 zeigt ein Ausführungsbeispiel, bei dem ein elektrisch-magnetisches Dipolfeld (21 bis 23) und ein Rückstreudetektor (14 bis 17) nach Figur 1 auf der von der Probe 5 abgewandten Seite einer Projektionslinse 4" vorgesehen sind. Die Projektionslinse 4' ist als eine Immersionslinse ausgebildet. Der Primärstrahl ist durch gestrichelte Linien 53 angedeutet. Die Sekundärelektronen 54 werden durch die Immersionslinse 4" beschleunigt und durch das Dipolfeld zur Elektrode 21 hin abgesaugt. Auch hier ist der Einsatz eines elektrisch-magnetischen Quadrupols nach Figur 3 zum Absaugen der Sekundärelektronen möglich.

Die Figuren 4 und 5, die die zuletzt beschriebenen Ausführungsbeispiele nur teilweise wiedergeben, können jeweils durch die in Figur 1 zusätzlich dargestellten Teile ergänzt werden.

Die Erfindung ist insbesondere bei Geräten der Elektronenstrahllithografie, der Elektronenstrahlmeßtechnik und der Rasterelektronenmikroskopie anwendbar, wobei vor allem das Ausführungsbeispiel nach Figur 4 einen kleinen Arbeitsabstand zwischen Probe und Projektionslinse bzw. eine kurze Brennweite der letzteren und damit eine hohe örtliche Auflösung der Probenoberfläche auch bei sehr ausgedehnten Proben sowie eine einwandfreie Eelektronendetektion gewährleistet.

**Patentansprüche**

1. Anordnung zur Detektion von Sekundär- und/oder Rückstreuelektronen in einem Elektronenstrahlgerät, bei dem ein mittels einer Objektivlinse (4) fokussierter Primärstrahl (2) auf einen Punkt (13) oder sequentiell auf eine Reihe von Punkten einer Probe (5) gerichtet wird und bei dem an den Punkten austretende Sekundärelektronen (SE) und/oder Rückstreuelektronen ein elektrisches Absaugfeld durchlaufen und zu einem Detektor (14 bis 17) gelangen, **dadurch gekennzeichnet,** daß in einer zur elektronenoptischen Achse (7) senkrechten Ebene zwei Elektroden (21, 22) angeordnet sind, zwischen denen ein die Sekundärelektronen und/oder Rückstreuelektronen zu der einen Elektrode (21) hin absaugendes elektrisches Feld vorhanden ist, daß sich der Detektor hinter dieser Elektrode befindet, daß in der genannten Ebene zwei Magnetpolstücke (23, 24) vorgesehen sind, zwischen denen ein auf das elektrische Feld senkrecht stehendes magnetisches Feld vorhanden ist, und daß Stärke und Richtung des magnetischen Feldes so gewählt sind, daß es auf die Elektronen des Primärstrahls (2) eine Kraft ausübt, die die durch das elektrische Feld auf diese ausgeübte Kraft kompensiert, jedoch auf die Sekundärelektronen (SE) und/oder Rückstreuelektronen eine Kraft ausübt, die das Absaugen derselben auf den Detektor hin unterstützt.

2. Anordnung nach Anspruch 1, **dadurch gekennzeichnet,** daß in der genannten Ebene vier Elektroden (26 bis 29) jeweils entlang der Seitenlinien eines Quadrates, dessen Mittelpunkt etwa in der elektronenoptischen Achse (7) liegt, angeordnet sind, daß zwei von diesen Elektroden (26, 28), die etwa symmetrisch zu dieser Achse liegen, mit einem ersten Potential beaufschlagt sind, daß die anderen beiden (27, 29) auf einem zweiten, gegenüber dem ersten negativen Potential liegen, daß jeweils zwischen zwei einander benachbarten Elektroden ein elektrisches Absaugfeld besteht, das die Sekundärelektronen zu der auf dem ersten Potential liegenden Elektrode (26) hin absaugt, daß hinter den beiden auf dem ersten Potential liegenden Elektroden (26, 28) jeweils ein Detektor vorgesehen ist, daß vier Magnetpolstük-ke (38 bis 41) vorgesehen sind, von denen jeweils eines zwischen zwei einander benachbarten Elektroden angeordnet ist, daß jeweils zwei zu der elektronenoptischen Achse etwa symmetrisch liegende Magnetpolstücke die gleiche Polarität aufweisen und daß zwischen jeweils zwei einander benachbarten Magnetpolstücken (38, 41), die beiderseits zu einer auf dem ersten Potential liegenden Elektrode (26) angeordnet sind, ein Magnetfeld vorhanden ist, das auf dem für diese Elektrode (26) wirksamen Absaugfeld senkrecht steht.

3. Anordnung nach Anspruch 2, **dadurch gekennzeichnet,** daß die Magnetpolstücke (38 bis 41) weiter von der elektronenoptischen Achse entfernt sind als die Elektroden (26 bis 29).

4. Anordnung nach einem der Ansprüch 1 bis 3, **dadurch gekennzeichnet,** daß die Elektroden (26 bis 29) aus einem Material mit einer Permeabilität $\mu m \approx 1$ bestehen.

5. Anordnung nach einem der Ansprüche 1 bis 4, **gekennzeichnet durch** eine gitterförmige Ausbildung der Elektrode (21, 26), hinter der ein Detektor (14 bis 17; 30, 32, 34, 36) vorgesehen ist.

6. Anordnung nach einem der Ansprüche 1 bis 5, **dadurch gekennzeichnet,** daß der Detektor aus einem Szintillator (14) und einem mit diesem über einen Lichtleiter (15) verbundenen Fotomultiplier (16) besteht, an dessen Ausgang (17) ein elektrisches Signal abgreifbar ist.

7. Anordnung nach einem der Ansprüche 1 bis 6, **dadurch gekennzeichnet,** daß die Elektroden (21, 22) und Magnetpolstücke (23, 24) zwischen der Objektivlinse (4) und der Probe (5) angeordnet sind.

8. Anordnung nach einem der Ansprüche 1 bis 6, **dadurch gekennzeichnet,** daß die Elektroden (21', 22') und Magnetpolstücke (50) im Innenraum der Projektionslinse (4') oder in oder in der Nähe des Luftspaltes ihres metallischen Mantels (8') angeordnet sind.

9. Anordnung nach Anspruch 8, **dadurch gekennzeichnet,** daß der metallische Mantel (8') der Projektionslinse (4') eine Bohrung (46) aufweist, durch die der Lichtleiter (15') eines aus Szintillator (14'), Lichtleiter (15') und Fotomultiplier (16') bestehenden Detektors aus dem Innenraum der Projektionslinse herausgeführt ist.

10. Anordnung nach einem der Ansprüche 8 und 9, **gekennzeichnet durch** die Anordnung von Spektrometergittern (51, 52) in oder in der Nähe der Bohrung des metallischen Mantels (8') der Projektionslinse (4').

11. Anordnung nach einem der Ansprüche 1 bis 6, **dadurch gekennzeichnet,** daß die Elektroden (21, 22) und Magnetpolstücke (23) auf der von der Probe (5) abgewandten Seite der Probjektionslinse (4") liegen und daß diese als Immersionslinse ausgebildet ist.

**Claims**

1. Arrangement for the detection of secondary and/or back-scattering electrons in an electron beam apparatus, in which a primary beam (2), focused by an objective lens (4), is directed onto to a point (13), or sequentially onto a series of points, of a specimen (5), and in which secondary electrons (SE) and/or back-scattering electrons emerging at the points flow through an attracting electrical field and arrive at a detector (14 to 17), characterised in that, in a plane perpendicular to the electron-optical axis (7), two electrodes (21, 22) are arranged, between which there is an electrical field for attracting the secondary electrons and/or back-scattering electrons towards one electrode (21), in that the detector is located behind this electrode, in that two magnetic pole pieces (23, 24) are provided in the said plane, between which there is a magnetic field perpendicular to the electrical field, and in that the strength and direction of the magnetic field are selected such that it exerts a force on the electrons of the primary beam (2) which compensates for the force exerted on them by the electrical field, but exerts a force on the secondary electrons (SE) and/or back-scattering electrons which supports the attraction of the same to the detector.

2. Arrangement according to Claim 1, characterised in that four electrodes (26 to 29) are arranged in the said plane, in each case along lines forming the sides of a square whose centre is located approximately in the electron-optical axis (7), in that two of these electrodes (26, 28), which are located approximately symmetrically with respect to this axis, are subjected to & first potential, in that the other two electrodes (27, 29) are at a second potential, negative with respect to the first potential, in that in each case between two mutually adjacent electrodes there is an attracting electrical field which attracts the secondary electrons towards the electrode (26) at the first potential, in that a detector is provided behind each of the two electrodes (26, 28) at the first potential, in that four magnetic pole pieces (38 to 41) are provided, one of which is in each case arranged between two mutually adjacent electrodes, in that in each case two magnetic pole pieces located approximately symmetrically with respect to the electron-optical axis exhibit the same polarity, and in that between in each case two mutually adjacent magnetic pole pieces (38, 41), which are arranged on both sides of an electrode (26) at the first potential, there is a magnetic field which is perpendicular to the attractive field that is effective for this electrode (26).

3. Arrangement according to Claim 2, characterised in that the magnetic pole pieces (38 to 41) are further away from the electron-optical axis than are the electrodes (26 to 29).

4. Arrangement according to one of Claims 1 to 3, characterised in that the electrodes (26 to 29) consist of a material having a permeability $\mu \approx 1$.

5. Arrangement according to one of Claims 1 to 4, characterised by a grid-shaped design of the electrode (21, 26), behind which a detector (14 to 17; 30, 32, 34, 36) is provided.

6. Arrangement according to one of Claims 1 to 5, characterised in that the detector consists of a scintillator (14) and, connected thereto via a light conductor (15), a photomultiplier (16), at whose output (17) an electrical signal can be picked up.

7. Arrangement according to one of Claims 1 to 6, characterised in that the electrodes (21, 22) and magnetic pole pieces (23, 24) are arranged between the objective lens (4) and the specimen (5).

8. Arrangement according to one of Claims 1 to 6, characterised in that the electrodes (21', 22') and magnetic pole pieces (50) are arranged in the interior of the projection lens (4') or in, or near, the air gap of its metallic covering (8').

9. Arrangement according to Claim 8, characterised in that the metallic covering (8') of the projection lens (4') exhibits a bore hole (46), through which the light conductor (15') of a detector consisting of a scintillator (14'), light conductor (15') and photomultiplier (16') is led out from the interior of the projection lens.

10. Arrangement according to one of Claims 8 and 9, characterised by the arrangement of spectrometer grids (51, 52) in, or near, the bore hole of the metallic covering (8') of the projection lens (4').

11. Arrangement according to one of Claims 1 to 6, characterised in that the electrodes (21, 22) and magnetic pole pieces (23) are located on the side of the projection lens (4") remote from the specimen and that this lens is designed as an immersion lens.

## Revendications

1. Dispositif pour détecter des électrons secondaires ou des électrons de rétrodiffusion dans un appareil à faisceau électronique, dans lequel un faisceau primaire (2) est focalisé au moyen d'un objectif (4), est dirigé sur un point (13) ou successivement sur une série de points d'un échantillon (5) et dans lequel des électrons secondaires (SE) et/ou des électrons de rétrodiffusion, sortant au niveau des points, traversent un champ électrique d'aspiration et atteignent un détecteur (14 à 17), caractérisé par le fait que dans un plan perpendiculaire à l'axe électro-optique (7) sont disposées deux électrodes (21,22), entre lesquelles est présent un champ électrique qui aspire les électrons secondaires ou les électrons de rétrodiffusion en direction d'une électrode (21), que le détecteur est situé derrière cette électrode, que dans ledit plan il est prévu deux pièces polaires magnétiques (23,24), entre lesquelles est présent un champ magnétique perpendiculaire au champ électrique, et que l'intensité et la direction du champ magnétique sont choisies de manière que ce dernier exerce sur les électrons du faisceau primaire (2) une force qui compense la force exercée sur ces électrons par le champ électrique, mais exerce sur les électrons secondaires (SE) et/ou les électrons de rétrodiffusion, une force qui favorise l'aspiration des électrons en direction du détecteur.

2. Dispositif suivant la revendication 1, caractérisé par le fait que quatre électrodes (26 à 29) sont déposées dans ledit plan, respectivement le long des lignes des côtés d'un carré, dont le centre est situé approximativement sur l'axe électro-optique (7), que deux de ces électrodes (26,28), qui sont approximativement symétrique par rapport à cet axe, sont chargées à un premier potentiel, que les deux autres électrodes (27,29) sont placées à un second potentiel négatif par rapport au premier potentiel, que respectivement entre deux électrodes réciproquement voisines existe un champ électrique d'aspiration, qui aspire les électrons secondaires en direction de l'électrode (26) placée au premier potentiel, qu un détecteur est prévu respectivement derrière les deux électrodes (26,28) placées au premier potentiel, qu'il est prévu quatre pièces polaires magnétiques (38 à 41), dont respectivement l'une est disposée entre deux électrodes réciproquement voisines, que respectivement deux pièces polaires magnétiques approximativement symétriques par rapport à l'axe électrooptique possèdent la même polarité et qu'entre respectivement deux pièces polaires magnétiques réciproquement voisines (38, 41), qui sont disposées des deux côtés d'une électrode (26) placée au premier potentiel, il existe un champ magnétique perpendiculaire au champ d'aspiration actif pour cette électrode (26).

3. Dispositif suivant la revendication 2, caractérisé par le fait que les pièces polaires magnétiques (38 à 41) sont plus éloignées de l'axe électro-optique que ne le sont les électrodes (26 à 29).

4. Dispositif suivant l'une des revendications 1 à 3, caractérisé par le fait que les électrodes (26 à 29) sont réalisées en un matériau possédant une perméabilité $\mu \approx 1$.

5. Dispositif suivant l'une des revendications 1 à 4, caractérisé par une réalisation en forme de grille de l'électrode (21,28), derrière laquelle est prévu un détecteur (14 à 17; 30, 32, 34, 36).

6. Dispositif suivant l'une des revendications 1 à 5, caractérisé par le fait que le détecteur est constitué par un scintillateur (14) et un photomultiplicateur (16) qui est raccordé à ce scintillateur par l'intermédiaire d'un guide de lumière (15) et à la sortie (17) duquel peut être prélevé un signal électrique.

7. Dispositif suivant l'une des revendications 1 à 6, caractérisé par le fait que l'électrode (21,22) et les pièces polaires magnétiques (23,24) sont disposées entre l'objectif (4) et l'échantillon (5).

8. Dispositif suivant l'une des revendications 1 à 6, caractérisé par le fait que les électrodes (21',22') et les pièces polaires magnétiques (50) sont disposées dans l'espace intérieur de la lentille de projection (4') ou dans l'entrefer ou à proximité de l'entrefer de l'enveloppe métallique (8') de cette lentille.

9. Dispositif suivant la revendication 8, caractérisé par le fait que l'enveloppe métallique (8') de la lentille de projection (4') possède un perçage (46), par lequel le guide de lumière (15') d'un détecteur constitué par un scintillateur (14'), un guide de lumière (15') et un photomultiplicateur (16'), sort de l'espace intérieur de la lentille de projection.

10. Dispositif suivant l'une des revendications 8 et 9, caractérisé par la disposition de réseaux (51,52) d'un spectromètre dans ou à proximité du perçage de l'enveloppe métallique (8') de la lentille de protection (4').

11. Dispositif suivant l'une des revendications 1 à 6, caractérisé par le fait que les électrodes (21,22) et les pièces polaires magnétiques (23) sont situées du côté de la lentille de protection (4"), tournée à l'opposé de l'échantillon (5), et que cette lentille est réalisée sous la forme d'une lentille à immersion.

# FIG 1

# FIG 2

# FIG 5

# FIG 3

# FIG 4